# EUROPEAN PATENT SPECIFICATION

(11) **EP 0 452 777 B1**
(45) Date of publication and mention of the grant of the patent: **28.02.1996**
(21) Application number: 91105627.3
(22) Date of filing: 09.04.1991
(51) Int. Cl.: H01L 21/00

(54) **Wafer heating and monitoring system and method of operation**
Heizungs- und Überwachungssystem für eine Halbleiterscheibe und Wirkungsweise
Système de chauffe et de surveillance d'une plaquette et méthode d'utilisation

(30) Priority: 19.04.1990 US 510710
(43) Date of publication of application: 23.10.1991
(73) Proprietor: APPLIED MATERIALS INC., Santa Clara California 95052 (US)
(72) Inventor: Nulman, Jaim, Palo Alto, California 94306 (US); Maydan, Dan, Los Altos Hills, California 94022 (US)
(74) Representative: Kahler, Kurt, Dipl.-Ing.

(56) References cited:
- US-A- 4 891 499

## Description

### Field of the Invention

The present invention relates to the heat treatment of integrated circuit wafers, to apparatus and methods for measuring the temperature of IC wafers during the heat treatment thereof, and, in particular, to apparatus and methods for monitoring the temperature of wafers during the annealing of integrated circuit metallisation formed on the wafers.

### Background of the Invention

Annealing metallization formed on integrated circuit wafers requires accurate control of the semiconductor wafer temperature and, thus, accurate monitoring of the wafer temperature. Perhaps the preferred temperature monitoring technique for such wafers uses IR (infrared) sensors to detect the heat energy emitted from the wafer. IR sensing is preferred in part because the sensor can be located remotely, outside the processing chamber, and because of the potential accuracy of this technology. However, the potential accuracy of the IR sensing technology has not been fully realized, in part because the varied topography and the constituent materials of the integrated circuit structures formed on a wafer make it difficult to accurately monitor the temperature of the wafer.

US-A-4,891,499 discloses an apparatus for measuring the temperature of a wafer during a heating treatment, wherein a silicon semiconductor wafer is placed in a vacuum chamber device side facedown and laser beams of equal power are directed at an edge point and a center point of the wafer. The laser beams are reflected from the edge point and the center point into first and second infrared photodetectors. A differential amplifier evaluates the reflected laser beams for a power difference and signals a current source. The current source heats a quartz ring which surrounds the wafer. The quartz ring passes the heat to the wafer until the amplifier no longer senses a power difference, which is indicative of an equal wafer surface temperature. This apparatus, however, does not take account of the different local properties of the wafer due to the topography of the wafer.

### Summary of the Invention

In view of the above discussion, it is a primary object of our present invention to provide an apparatus and a process for accurately heating a semiconductor wafer and for accurately monitoring the temperature of a semiconductor wafer during its heat treatment, in particular during the annealing of metallization on the wafer.

In one aspect, the above and other objects are accomplished by heating the wafer via a susceptor and by measuring the temperature of the wafer indirectly based upon the temperature of the susceptor, independent of the backside conditions of the wafer. Apparatus which embodies this concept comprises: a thin susceptor of constant, high emissivity; means for mounting the susceptor with substantially the entire backside area thereof exposed; means for irradiating the susceptor from at least the backside thereof; and means for monitoring the temperature of the backside of the susceptor. Preferably, the susceptor is material such as silicon carbide or silicon carbide-coated graphite to provide the constant, high emissivity characteristics and is approximately 0.5 - 8 mm (millimeters) thick to provide fast thermal response.

In another aspect, the means for mounting the susceptor comprises a plurality of fingers arranged for peripherally engaging the susceptor.

In still another more specific aspect, the means for monitoring the temperature of the susceptor is an infrared sensor or a thermocouple.

Our present invention is also embodied in a process for measuring or monitoring the temperature of a wafer independently of the backside conditions of the wafer, comprising: providing a thin, constant high emissivity susceptor; supporting a semiconductor wafer on the susceptor; radiantly heating the susceptor from at least the backside thereof; and monitoring the temperature of the wafer indirectly by monitoring the temperature of the susceptor. The susceptor temperature can be monitored using a thermocouple attached to the susceptor or by sensing thermal energy emitted from the backside thereof.

In yet another aspect, our process comprises the step of calibrating the susceptor relative to the temperature of the wafer by monitoring the temperature of the wafer and the susceptor over a range of temperatures and determining the differences between the wafer and susceptor temperatures over that range.

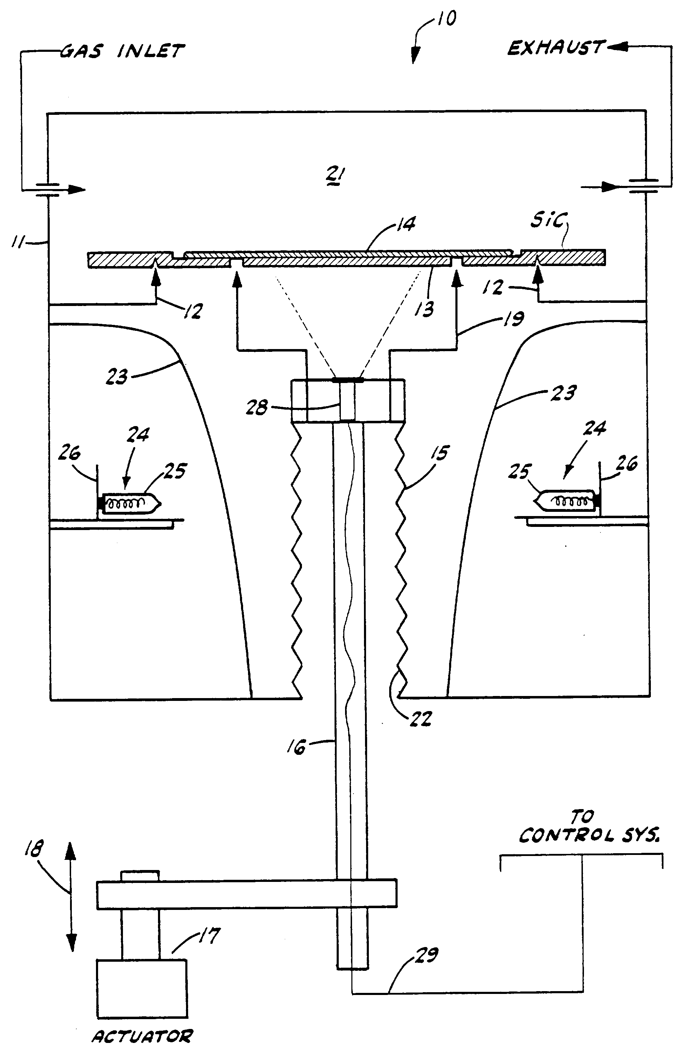

### Brief Description of the Drawing

The above and other aspects of the invention are described with respect to the attached drawing which schematically depicts a wafer annealing system which incorporates wafer heating and wafer temperature monitoring capability in accordance with our present invention.

### Detailed Description of the Preferred Embodiments

The figure schematically depicts an example of a wafer temperature monitoring system made in accordance with our present invention, which is incorporated into a wafer annealing system 10. The system 10 includes a vacuum chamber or housing 11. Within the chamber are a plurality of quartz support pins 12 which support a susceptor 13 about its periphery and thus leave exposed substantially all the backside of the susceptor (the bottom side in the figure). The susceptor 13 supports a wafer 14. A combination wafer lift/infrared sensor assembly 15 includes an elevator 16 which is vertically reciprocated by an actuator mechanism 17 along a path indicated generally by arrow 18. Mounted on the upper end of the elevator 16 is a quartz wafer lifter 19 which includes a plurality of pins mounted on a support ring (not shown) for transferring the wafer 14 from the susceptor 13 to a wafer transfer blade (not shown) and vice versa.

The process chamber 21 is isolated from the lift mechanism 15 by a bellows 22 and is isolated from radiant lamp assembly 24 by an envelope or window 23. The susceptor 13 is uniformly heated through the window 23 by the circular array of lamps 25 and the associated reflector assembly 26. Presently, the lamps are infrared and the radiant-energy-transparent window 23 is quartz. Radiant energy lamps or other heating means can be provided at the front side of the wafer as well. Our system for quickly and accurately tracking the temperature of the wafer, and thus accurately monitoring the wafer temperature, also provides fast efficient radiant heating of the wafer which closely tracks the temperature of the susceptor.

Our radiantly heated wafer annealing system 10 includes means for measuring the temperature of the wafer 14 via the susceptor 13, free of the backside conditions of the wafer. The temperature measurement means comprises a thermocouple mounted to or embedded in the susceptor 13 or, preferably, an infrared sensor in the form of a pyrometer 28 mounted beneath the susceptor, illustratively on the wafer lift elevator 16. Output signals from the thermocouple or pyrometer are applied via line(s) 29 to a computer control system. The closed loop control system uses the temperature data signals obtained from the susceptor to control processing of the wafer and, if desired, to provide a readout of susceptor temperature. Those of usual skill in the art will readily understand that the temperature of the wafer is obtained from that of the susceptor by measuring the actual wafer temperature over a range of susceptor temperatures so that the susceptor temperatures can be calibrated to the wafer temperatures over the range.

Our indirect measurement technique, i. e., accurately monitoring the temperature of the wafer indirectly by monitoring the temperature of the susceptor, is made possible by specially adapting the susceptor to the process. First, the susceptor 13 is an optically opaque material having a constant emissivity over the temperature and wavelength ranges of interest.

Preferably, the susceptor is formed of graphite coated with silicon carbide or is solid silicon carbide. The associated emissivity is approximately 0.9. Those of usual skill in the art will derive other materials, compounds and combinations of materials which provide the necessary emissivity so that one can put the wafer on the front side of the susceptor and accurately monitor the temperature thereof via the backside. Secondly, the susceptor is very thin, typically 0.5 mm - 8 mm, and preferably 2 mm, to provide a very fast response time so that the susceptor quickly and closely tracks the temperature of the wafer and vice versa.

The above features which accurately provide for monitoring of the wafer heating during processing also effect accurate heating itself. That is, our "indirect" heating of the wafer by conduction from the backside-heated, thin, constant emissivity susceptor also permits quick, accurate uniform heating of the wafer during both the fabrication of layers on the wafer (for example, the formation of silicide layers) and during annealing of such layers.

### Example of Annealing Process

The following is a description of one exemplary process for annealing metallization on a semiconductor wafer.

Initially, a robot arm is used to load the wafer onto the susceptor under vacuum conditions of at least about 10⁻⁷ torr. Once the wafer is in place, the robot arm is retracted and the associated chamber opening closed to isolate the chamber from the transfer chamber. Then the chamber is back-filled to atmospheric pressure (800 torr) or to any level of vacuum, with gas or mixtures such as N₂, NH₃, Ar, forming gas, a combination of nitrogen and oxygen, a combination of argon and oxygen, etc. Once the gas conditions are established, the computer (1) controls the operation of the lamps to ramp up the temperature of the susceptor and wafer at the programmed rate to the process set point and then (2) maintains a constant susceptor temperature (or varies the temperature as required). Typically, temperatures of 300°C - 1,000°C are used for annealing metals, which can be refractory metal such as silicides, aluminum, aluminum composites such as aluminum silicon, aluminum copper, aluminum silicon copper or basically any metal used in the semiconductor industry.

In addition to the above-described advantages, the present temperature-monitoring apparatus and process have the advantage of very little background noise. This is important at lower temperatures, where the amount of energy emitted from the wafer or susceptor is reduced and the process is sensitive to background noise. In addition, at temperatures below about 600°C, the silicon wafers are thermally transparent and the effect of front side structures is increased.

## Claims

1. An apparatus (10) for measuring the temperature of a semiconductor wafer (14) independent of the backside condition of the wafer, during the heat treatment thereof, comprising:
a thin, high emissivity susceptor (13) for providing fast thermal response between the susceptor (13) and a wafer (14) supported on the front side of the susceptor (13), the susceptor (13) also having a constant emissivity;
means (12) for mounting the susceptor (13) with substantially the entire backside area thereof exposed;
means (24) for irradiating the susceptor from at least the backside thereof; and
means (28) for monitoring the temperature of the backside of the susceptor.

2. The apparatus of claim 1, wherein emissivity of the susceptor (13) is about 0.9 and the susceptor (13) is approximately 0.5 mm to 8 mm thick.

3. The apparatus of claim 1 or 2, wherein the susceptor (13) is silicon carbide or silicon carbide-coated graphite.

4. The apparatus of any of the claims 1 to 3, wherein the means for mounting the susceptor (13) comprises a plurality of fingers (12) arranged for engaging the periphery of the susceptor (13).

5. The apparatus of any of the claims 1 to 4, wherein the means for monitoring the temperature of the backside of the susceptor (13) is an infrared sensor or a thermocouple (28).

6. A Method for monitoring the temperature of a semiconductor wafer (14), independent of the backside conditions of the wafer, during the heat treatment thereof, comprising:
providing a very thin, constant high emissivity susceptor (13);
supporting the susceptor (13) so as to leave substantially all of the backside of the susceptor (13) uncovered;
supporting a semiconductor wafer (14) on the front side of the susceptor (13);
radiantly heating the susceptor (13) from at least the backside thereof; and
monitoring the temperature of the wafer indirectly by monitoring the temperature of the backside of the susceptor (13).

7. The method of claim 6, wherein the emissivity of the susceptor (13) is about 0.9 and the susceptor (13) is approximately 0.5 mm to 8 mm thick.

8. The method of claim 6 or 7, wherein the susceptor (13) is silicon carbide or silicon carbide-coated graphite.

9. The method of any of the claims 6 to 8, wherein the susceptor temperature is measured using a thermocouple (28) attached to the susceptor (13) or by sensing thermal energy emitted from the backside thereof.

10. The method of any of the claims 6 to 9, further comprising the step of calibrating the susceptor (13) relative to the temperature of the wafer by monitoring the temperature of the wafer (14) and the susceptor (13) over a range of temperatures and determining the difference in temperature between the wafer (14) and the susceptor (13) over the temperature range.

## Patentansprüche

1. Eine Vorrichtung (10) zum Messen der Temperatur einer Halbleiterscheibe (14) unabhängig vom Zustand der Rückseite der Halbleiterscheibe während deren Wärmebehandlung, die aufweist:
einen dünnen Materialhalter (13) mit hohem Emissionsvermögen zum Vorsehen einer schnellen thermischen Reaktion zwischen dem Materialhalter (13) und einer Halbleiterscheibe (14), die auf der Vorderseite des Materialhalters (13) abgestützt ist, wobei der Materialhalter (13) auch ein konstantes Emissionsvermögen aufweist;
eine Einrichtung (12) zum Befestigen des Materialhalters (13), wobei im wesentlichen die gesamte Fläche der Rückseite von diesem freigelegt ist;
eine Einrichtung (24) zum Bestrahlen des Materialhalters von zumindest dessen Rückseite aus; und
eine Einrichtung (28) zum Überwachen der Temperatur der Rückseite des Materialhalters.

2. Die Vorrichtung nach Anspruch 1, wobei das Emissionsvermögen des Materialhalters (13) etwa 0,9 beträgt und der Materialhalter (13) etwa 0,5 mm bis 8 mm dick ist.

3. Die Vorrichtung nach Anspruch 1 oder 2, wobei der Materialhalter (13) aus Siliciumcarbid oder siliciumcarbidbeschichtetem Graphit besteht.

4. Die Vorrichtung nach einem der Ansprüche 1 bis 3, wobei die Einrichtung zum Befestigen des Materialhalters (13) eine Vielzahl von Fingern (12) aufweist, die so angeordnet sind, daß sie mit der Peripherie des Materialhalters (13) in Eingriff bringbar sind.

5. Die Vorrichtung nach einem der Ansprüche 1 bis 4, wobei die Einrichtung zum Überwachen der Temperatur der Rückseite des Materialhalters (13) ein Infrarotsensor oder ein Thermoelement (28) ist.

6. Ein Verfahren zum Überwachen der Temperatur einer Halbleiterscheibe (14) unabhängig von den Zuständen der Rückseite der Halbleiterscheibe während deren Wärmebehandlung, das aufweist:
Vorsehen eines sehr dünnen Materialhalters (13) mit einem konstanten, hohen Emissionsvermögen;
Abstützen des Materialhalters (13), so daß im wesentlichen die gesamte Rückseite des Materialhalters (13) unbedeckt gelassen wird;
Abstützen einer Halbleiterscheibe (14) auf der Vorderseite des Materialhalters (13);
Strahlungserwärmen des Materialhalters (13) von zumindest dessen Rückseite aus; und
indirektes Überwachen der Temperatur der Halbleiterscheibe durch Überwachen der Temperatur der Rückseite des Materialhalters (13).

7. Das Verfahren nach Anspruch 6, wobei das Emissionsvermögen des Materialhalters (13) etwa 0,9 beträgt und der Materialhalter (13) etwa 0,5 mm bis 8 mm dick ist.

8. Das Verfahren nach Anspruch 6 oder 7, wobei der Materialhalter (13) aus Siliciumcarbid oder siliciumcarbidbeschichtetem Graphit besteht.

9. Das Verfahren nach einem der Ansprüche 6 bis 8, wobei die Materialhalter-Temperatur unter Verwendung eines Thermoelements (28), das an dem Materialhalter (13) befestigt ist, oder durch Erfassen der von dessen Rückseite abgestrahlten Wärmeenergie gemessen wird.

10. Das Verfahren nach einem der Ansprüche 6 bis 9, ferner aufweisend den Schritt des Kalibrierens des Materialhalters (13) relativ zur Temperatur der Halbleiterscheibe durch Überwachen der Temperatur der Halbleiterscheibe (14) und des Materialhalters (13) über einen Bereich von Temperaturen und Bestimmen des Temperaturunterschieds zwischen der Halbleiterscheibe (14) und dem Materialhalter (13) über den Temperaturbereich.

## Revendications

1. Appareil (10) destiné à mesurer la température d'une tranche de semi-conducteur (14) indépendamment des conditions de la face arrière de la tranche, pendant le traitement thermique de celle-ci, comprenant : un suscepteur mince (13) à pouvoir émissif relatif élevé destiné à procurer une réponse thermique rapide entre le suscepteur (13) et une tranche (14) maintenue sur la face avant du suscepteur (13), le suscepteur (13) présentant également un pouvoir émissif relatif constant,
un moyen (12) destiné au montage du suscepteur (13), la surface de face arrière complète de celui-ci étant sensiblement exposée,
un moyen (24) destiné à rayonner sur le suscepteur depuis au moins la face arrière de celui-ci, et
un moyen (28) destiné à surveiller la température de la face arrière du suscepteur.

2. Appareil selon la revendication 1, dans lequel le pouvoir émissif relatif du suscepteur (13) est d'environ 0,9 et le suscepteur (13) est approximativement de 0,5 à 8 mm d'épaisseur.

3. Appareil selon la revendication 1 ou la revendication 2, dans lequel le suscepteur (13) est fait de carbure de silicium ou de graphite revêtu de carbure de silicium.

4. Appareil selon l'une quelconque des revendications 1 à 3, dans lequel le moyen destiné au montage du suscepteur (13) est constitué d'une pluralité de doigts (12) agencés de façon à engager la périphérie du suscepteur (13).

5. Appareil selon l'une quelconque des revendications 1 à 4, dans lequel le moyen destiné à surveiller la température de la face arrière du suscepteur (13) est un détecteur à infra rouge ou un thermocouple (28).

6. Procédé destiné à la surveillance de la température d'une tranche de semi-conducteur (14), indépendamment des conditions de la face arrière de la tranche, pendant le traitement thermique de celle-ci, comprenant :
la fourniture d'un suscepteur très mince (13) à pouvoir émissif relatif élevé constant,
le soutien du suscepteur (13) de façon à laisser sensiblement toute la face arrière du suscepteur (13) découverte,
le soutien d'une tranche de semi-conducteur (14) sur la face avant du suscepteur (13),
le chauffage par rayonnement du suscepteur (13) depuis au moins la face arrière de celui-ci, et
la surveillance indirecte de la température de la tranche en surveillant la température de la face arrière du suscepteur (13).

7. Procédé selon la revendication 6, dans lequel le pouvoir émissif relatif du suscepteur (13) est d'environ 0,9 et le suscepteur (13) est approximativement de 0,5 mm à 8 mm d'épaisseur.

8. Procédé selon la revendication 6 ou la revendication 7, dans lequel le suscepteur (13) est fait de carbure de silicium ou de graphite revêtu de carbure de silicium.

9. Procédé selon l'une quelconque des revendications 6 à 8, dans lequel la température du suscepteur est mesurée en utilisant un thermocouple (28) fixé au suscepteur (13) ou en détectant l'énergie thermique émise depuis la face arrière de celui-ci.

10. Procédé selon l'une quelconque des revendications 6 à 9, comprenant en outre l'étape consistant à étalonner le suscepteur (13) vis à vis de la température de la tranche en surveillant la température de la tranche (14) et celle du suscepteur (13) sur une plage de températures et en déterminant la différence de température entre la tranche (14) et le suscepteur (13) sur la plage de températures.
